(19) Europäisches Patentamt
European Patent Office
Office européen des brevets

(11) **EP 4 467 968 A1**

(12) **EUROPEAN PATENT APPLICATION**
published in accordance with Art. 153(4) EPC

(43) Date of publication:
**27.11.2024 Bulletin 2024/48**

(21) Application number: **22920534.9**

(22) Date of filing: **12.12.2022**

(51) International Patent Classification (IPC):
***G01N 24/10*** (2006.01)

(52) Cooperative Patent Classification (CPC):
**G01N 24/10**

(86) International application number:
**PCT/JP2022/045713**

(87) International publication number:
**WO 2023/136015 (20.07.2023 Gazette 2023/29)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.01.2022 JP 2022005281**

(71) Applicant: **National Institutes for Quantum
Science and
Technology
Chiba 263-8555 (JP)**

(72) Inventors:
• **YAMAZAKI, Yuichi**
  **Chiba-shi, Chiba 263-8555 (JP)**
• **MASUYAMA, Yuta**
  **Chiba-shi, Chiba 263-8555 (JP)**
• **OHSHIMA, Takeshi**
  **Chiba-shi, Chiba 263-8555 (JP)**

(74) Representative: **Winter, Brandl - Partnerschaft
mbB
Alois-Steinecker-Straße 22
85354 Freising (DE)**

(54) **PHYSICAL QUANTITY DETECTING DEVICE, PHYSICAL QUANTITY DETECTING METHOD,
AND PHYSICAL QUANTITY DETECTING PROGRAM**

(57) Detection accuracy of physical quantity detection using a quantum sensor can be improved. A physical quantity detection device 1 includes a quantum sensor 2 that has a spin defect 2a, an excitation unit 4 that applies excitation energy to the spin defect 2a, an electromagnetic wave incident unit 3 that causes resonant electromagnetic waves for ground level of the spin defect 2a and electromagnetic waves for excitation level of the spin defect 2a to be incident on the spin defect 2a, and a light detection unit 5 that detects emission intensity of the spin defect 2a when receiving the excitation energy, the resonant electromagnetic waves for ground level, and the electromagnetic waves for excitation level, and detects a physical quantity on the basis of the emission intensity detected by the light detection unit 5.

FIG. 1

**EP 4 467 968 A1**

## Description

Technical Field

The present invention relates to a physical quantity detection device, a physical quantity detection method, and a physical quantity detection program for detecting a physical quantity using a quantum sensor.

Background Art

Conventionally, a physical quantity detection device and a physical quantity detection method for detecting physical quantities such as a magnetic field, strain, and temperature using a quantum sensor having a spin defect (NV center-nitrogen-vacancy complex defects in diamond and VSi-silicon vacancy defects in silicon carbide) in a solid have been proposed (see Patent Literature 1).

In such a physical quantity detection method using a quantum sensor having a VSi-single vacancy defect of silicon carbide, excitation energy and resonant electromagnetic waves are applied to the quantum sensor by utilizing the fact that the emission intensity of the VSi-single vacancy defect changes depending on the physical quantity, a change in emission intensity at the time of resonance of the ground level or the excitation level of the VSi-single vacancy defect is detected, and then the physical quantity can be detected.

However, a physical quantity detection method using a quantum sensor having a VSi-single vacancy defect of silicon carbide has a problem that a change in emission intensity is low. In particular, the change in emission intensity at the excitation level is very small, and it is difficult to measure the temperature in the case of using the excitation level. That is, in the conventional quantum sensor, since the sensitivity as a sensor is very low, there is a problem that the detection accuracy (measurement accuracy) of the physical quantity is lowered.

Citation List

Patent Literature

Patent Literature 1: US Patent No. 10529416

Summary of Invention

Technical Problem

In view of the above-described problems, an object of the present invention is to provide a physical quantity detection device, a physical quantity detection method, and a physical quantity detection program capable of improving detection accuracy of physical quantity detection using a quantum sensor.

Solution to Problem

The present invention is a physical quantity detection device, a physical quantity detection method, and a physical quantity detection program, the physical quantity detection device including: a quantum sensor that has a spin defect; excitation means that applies excitation energy to the spin defect; first electromagnetic wave generation means that generates resonant electromagnetic waves for ground level of the spin defect; second electromagnetic wave generation means that generates electromagnetic waves for excitation level of the spin defect; an electromagnetic wave incident unit that causes the resonant electromagnetic waves for ground level and the electromagnetic waves for excitation level to be incident on the spin defect; light detection means that detects emission intensity of the spin defect when receiving the excitation energy, the resonant electromagnetic waves for ground level, and the electromagnetic waves for excitation level; and a physical quantity detection unit that detects a physical quantity on the basis of the emission intensity detected by the light detection means.

Advantageous Effects of Invention

According to the present invention, it is possible to provide a physical quantity detection device, a physical quantity detection method, and a physical quantity detection program capable of improving detection accuracy of physical quantity detection using a quantum sensor.

Brief Description of Drawings

FIG. 1 is a block diagram illustrating a configuration of a physical quantity detection device.
FIG. 2 is an explanatory diagram illustrating an electronic structure in a spin defect.
FIG. 3 is a graph illustrating emission intensity when the frequency of resonant electromagnetic waves for ground level is changed.
FIG. 4 is a graph illustrating emission intensity when the frequency of electromagnetic waves for excitation level is changed.
FIG. 5 is an explanatory diagram illustrating an example of a physical quantity detection condition.
FIG. 6 is a flowchart illustrating physical quantity detection processing.
FIG. 7 is a block diagram illustrating a configuration of a physical quantity detection device according to a modification.

Description of Embodiments

Hereinafter, an embodiment of the present invention will be described with reference to the drawings.

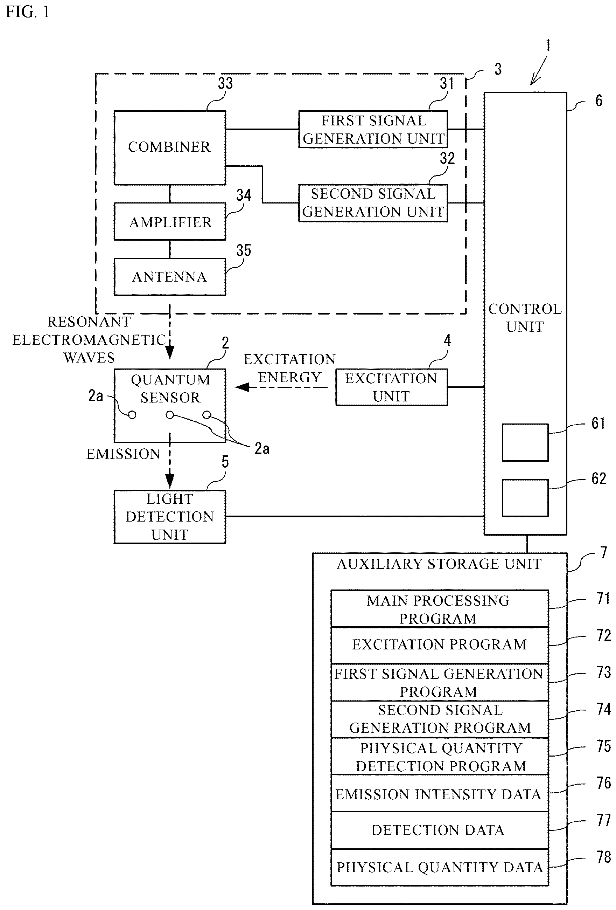

FIG. 1 is a block diagram illustrating a configuration of a physical quantity detection device 1. As illustrated in FIG. 1, the physical quantity detection device 1 includes a quantum sensor 2, an electromagnetic wave incident unit (electromagnetic wave irradiation unit) 3 that causes resonant electromagnetic waves to be incident (irradiated) on the quantum sensor 2, an excitation unit 4 that applies excitation energy to the quantum sensor 2, a light detection unit 5 that detects light from the quantum sensor 2, a control unit 6, and an auxiliary storage unit 7.

The quantum sensor 2 has an electron spin, and has a defect (hereinafter referred to as "spin defect") 2a in which the emission intensity changes at the time of resonance of the excitation level according to a change in physical quantity such as an electric field, pressure (strain), and temperature. The type of the spin defect 2a is not particularly limited as long as the spin defect 2a is formed in a solid material (base material), and the emission intensity at the time of resonance of the excitation level changes depending on the physical quantity. In the present embodiment, a case where the spin defect 2a is a silicon vacancy (SiC-VSi) of silicon carbide will be described as an example.

As a method of manufacturing the quantum sensor 2 having the spin defect 2a, a method of implanting ions, irradiating an electron beam, or irradiating a neutron beam into a base material crystal of silicon carbide or the like can be used. Alternatively, the defect may be a defect introduced intentionally or unintentionally during base material crystal growth. In addition, depending on the type of the spin defect 2a, a method of appropriately performing heat treatment can be used. Furthermore, in order to improve the optical characteristics of the spin defect 2a, heat treatment (high temperature treatment) may be performed at an appropriate temperature.

The electromagnetic wave incident unit 3 functions as an electromagnetic wave incident means (electromagnetic wave transmitting means) that causes (transmits) the resonant electromagnetic waves for ground level of the spin defect 2a and the electromagnetic waves for excitation level of the spin defect 2a to be incident on the spin defect 2a. The electromagnetic wave incident unit 3 includes a first signal generation unit 31, a second signal generation unit 32, a combiner 33, an amplifier 34, and an antenna 35.

The first signal generation unit 31 generates a signal (ground level signal) for generating the resonant electromagnetic waves for ground level. The second signal generation unit 32 generates a signal (excitation level signal) for generating electromagnetic waves for excitation level. The combiner 33 combines the ground level signal and the excitation level signal. The amplifier 34 amplifies the ground level signal and the excitation level signal combined by the combiner 33 to necessary signal intensity. The antenna 35 irradiates the spin defect 2a with the resonant electromagnetic waves for ground level according to the ground level signal amplified by the amplifier 34, and irradiates the spin defect 2a with the electromagnetic waves for excitation level according to the excitation level signal amplified by the amplifier 34. The antenna 35 is a rod-shaped or linear metal member, and is desirably provided such that the tip of the antenna 35 abuts on the vicinity of the quantum sensor 2 or the quantum sensor 2, but is not limited thereto.

The excitation unit 4 functions as excitation energy applying means for applying excitation energy to the quantum sensor 2 (spin defect 2a), and excites the spin defect 2a. As a method of applying excitation energy to the spin defect 2a, there is a method of irradiating excitation light, for example. In this case, the excitation unit 4 includes an excitation light source (Laser diode (LD), light emitting device (LED), and the like) for emitting excitation light. The wavelength of the excitation light can be a numerical value (wavelength) optimum for the spin defect to be used. The excitation unit 4 functions as an excitation light irradiation unit and irradiates the spin defect 2a with excitation light. For example, the spin defect 2a can be irradiated with excitation light corresponding to the energy difference between the ground level and the excitation level of the spin defect 2a to excite electrons of the spin defect 2a. Note that as a method of applying excitation energy to the spin defect 2a, a known method other than the method using excitation light can also be used.

The light detection unit 5 receives light from the quantum sensor 2 (spin defect 2a) and outputs an output signal corresponding to the intensity of incident (irradiated) light (emission intensity of spin defect 2a) to the control unit 6. The specific configuration of the light detection unit 5 is not particularly limited, and a photodiode or the like can be used. The light detection unit 5 is desirably capable of detecting weak light at a low bias, and a material, composition, configuration, and the like are selected according to the wavelength of light emission from the spin defect 2a. Additionally, an avalanche photodiode (APD) having high light receiving sensitivity and high S/N ratio may be used as the light detection unit 5.

The control unit (computer) 6 includes a calculation unit (CPU) 61 and a main storage unit (memory) 62 that stores various types of data. The control unit 6 executes at least temperature detection processing. That is, the control unit 6 functions as a temperature detection unit that detects (measures) a temperature on the basis of a signal output from the light detection unit 5. Note that the control unit 6 may function as a main control unit of the physical quantity detection device 1. In this case, the control unit 6 transmits a control signal to each part of the physical quantity detection device 1 such as the excitation unit 4, and causes the physical quantity detection device 1 to execute various operations.

The auxiliary storage unit 7 includes another non-volatile memory such as an HDD, an SSD, a flash memory, or an EEPROM, and stores a program and various types of data for the control unit 6 (calculation unit 61) to control the operation of the physical quantity detection device 1.

The auxiliary storage unit 7 stores at least a main processing program 71 for executing various operations of the physical quantity detection device 1, an excitation program 72 for controlling the excitation unit 4 to apply excitation energy to the spin defect 2a, a first signal generation program 73 for controlling the first signal generation unit 31 to generate a ground level signal, a second signal generation program 74 for controlling the second signal generation unit 32 to generate an excitation level signal, a physical quantity detection program 75 for detecting a physical quantity according to emission intensity data 76 based on the emission intensity input from the light detection unit 5, and the like.

In addition, the auxiliary storage unit 7 stores at least the emission intensity data 76 indicating an output value obtained by converting an output signal input from the light detection unit 5, detection data 77 which is data such as a detection condition for identifying (estimating) a physical quantity from the emission intensity data 76 (output value), data (physical quantity data) 78 of the physical quantity detected according to the physical quantity detection program 75, and the like. The detection data 77 is formula data for calculating a physical quantity from the emission intensity data 76 (output value), table data (calibration table data) for converting the emission intensity data 76 into a physical quantity, or the like.

In the quantum sensor 2 configured as described above, transition between states that can be taken by the electrons in the spin defect 2a can be operated from the outside. When excitation energy is applied, electrons in the spin defect 2a are excited via a quantum level (ground level, excitation level) formed between a valence band and a conduction band of a base material of the quantum sensor 2.

In addition, the physical quantity to be detected in the present embodiment is temperature, and in the present embodiment, temperature detection is performed using optical detection magnetic resonance (ODMR). Hereinafter, a case where temperature detection is performed in the physical quantity detection device 1 by using the optical detection magnetic resonance method will be described as an example.

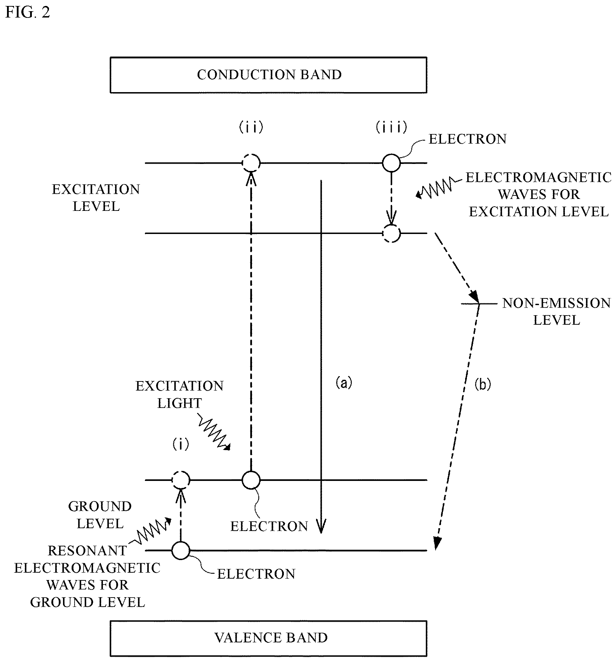

The excitation energy is applied under irradiation with resonant electromagnetic waves for ground level and electromagnetic waves for excitation level for operating the state of the electron spin. FIG. 2 is an explanatory diagram illustrating an electronic structure of a spin defect 2a (silicon vacancy (SiC-VSi) of silicon carbide). The resonant electromagnetic waves for ground level is electromagnetic waves for resonating electrons at the ground level, and the electromagnetic waves for excitation level is electromagnetic waves for resonating electrons at the excitation level.

As illustrated in FIG. 2, when the spin defect 2a is irradiated with the resonant electromagnetic waves for ground level in a case where the electrons are in the ground state (ground level), the electrons are brought into a state (resonance state) of being resonated at the ground level (i). When excitation energy is applied while the electrons are at the ground level, the electrons are excited to be in an excited state (excitation level) (ii). After staying for a predetermined period in this excited state (ii), electrons return to the ground state together with light emission with a certain probability (a). When light is not emitted, electrons return to the ground state through the non-emission level (b). Note that when the electrons are in the resonance state by the resonant electromagnetic waves for ground level before the excitation energy is applied, the probability that the electrons emit light becomes higher than when the electrons are not in the resonance state by the resonant electromagnetic waves for ground level (emission intensity of spin defect 2a becomes high).

In this process, in the present invention, the electromagnetic waves for excitation level are also irradiated (simultaneously). When the spin defect 2a is irradiated with the electromagnetic waves for excitation level in the electrons at the excitation level, the electrons enter a resonance state at the excitation level (iii). When the electrons enter the resonance state in the excited state, the probability that the electrons return to the ground state without emitting light increases. That is, by being irradiated with the electromagnetic waves for excitation level, the probability of light emission decreases, and eventually, the emission intensity decreases. Note, however, that the phenomenon (iii) in which the spin defect 2a is irradiated with the electromagnetic waves for excitation level and electrons enter a resonance state does not occur when the electromagnetic waves for excitation level deviates from the resonance frequency (frequency at which electrons resonate).

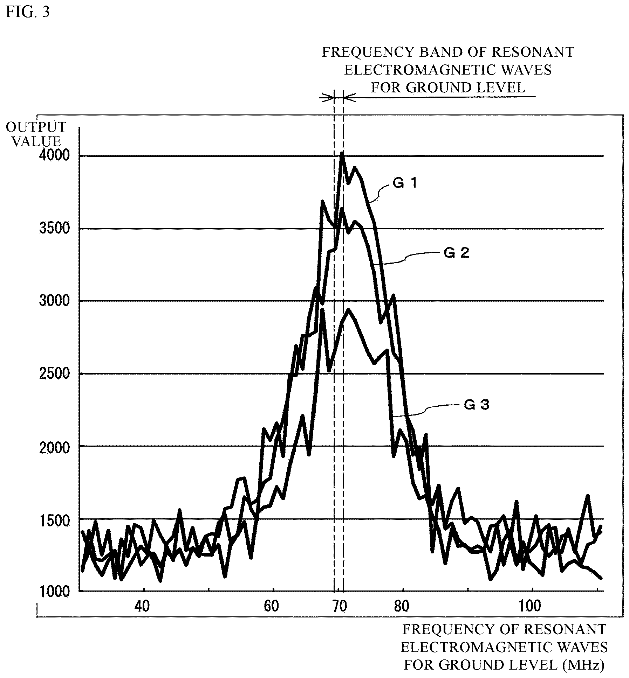

FIG. 3 is a graph showing the emission intensity of the spin defect 2a when the frequency of the electromagnetic waves for excitation level is fixed and the frequency of the resonant electromagnetic waves for ground level is changed. Specifically, FIG. 3 is a graph showing an emission intensity obtained by a test in which a resonance frequency of an excitation level at a certain temperature (test temperature) is examined, electromagnetic waves for excitation level are fixed to the resonance frequency of the excitation level at the test temperature, and the frequency of the resonant electromagnetic waves for ground level is changed (frequency is swept) by 1 MHz in a frequency band of 30 MHz to 110 MHz. In addition, the test according to FIG. 3 was performed three times while changing the intensity of the electromagnetic waves for excitation level. Specifically, the intensity of the electromagnetic waves for excitation level was increased in the order of the first test, the second test, and the third test. FIG. 3 illustrates the emission intensity (output value) of the spin defect 2a in the first test as an emission intensity G1 in the first test, the output value in the second test as an emission intensity G2 in the second test, and the emission intensity in the third test as G3.

As illustrated in FIG. 3, in a case where the frequency of the resonant electromagnetic waves for ground level is around 70 MHz (67 MHz to 73 MHz), in all of the emission intensity G1 in the first test, the emission intensity G2 in the second test, and the emission intensity G3 in the third test, the output value indicating the emission intensity of the spin defect 2a increases. This is because the resonance frequency of the ground level in the silicon vacancy (SiC-VSi) of silicon carbide which is the spin defect 2a of the present embodiment is 70 MHz. Since the resonance frequency of the ground level of the SiC-VSi has low temperature dependency, the resonance frequency remains at 70 MHz even if the temperature changes.

In addition, the emission intensity G2 in the second test is lower than the emission intensity G1 in the first test, and the emission intensity G3 in the third test is lower than the emission intensity G2 in the second test. That is, the emission intensity decreases as the intensity of the electromagnetic waves for excitation level increases. This is because a phenomenon ((iii) in FIG. 2) in which electrons are brought into a resonance state in an excited state frequently occurs when the intensity of the electromagnetic waves for excitation level is high. This is remarkable around 70 MHz (67 MHz to 73 MHz) of the resonance frequency of the ground level. In addition, the emission intensity G3 in the third test around the resonance frequency of the ground level decreases to about 1/2 to 2/3 of the emission intensity G1 in the first test, but even with the emission intensity G3 in the third test, the value increases by about one digit as compared with the emission intensity change in the case of irradiating only with the electromagnetic waves for excitation level which is a conventional temperature measurement method. Therefore, in the present invention, a larger change in emission intensity can be obtained, and the sensitivity is improved. The frequency of the resonant electromagnetic waves for ground level can be set within a range of 67 MHz to 73 MHz in which the amount of change in emission intensity due to the influence of the electromagnetic waves for excitation level is maximized, and is preferably fixed to 70 MHz. Additionally, for the spin defect 2a of the present embodiment, the frequency of the resonant electromagnetic waves for ground level is fixed within a range of 67 MHz to 73 MHz, and fixed to 70 MHz in the present embodiment, whereby higher emission intensity can be obtained. Note that when a material other than SiC-VSi is used as the spin defect 2a, the frequency of the resonant electromagnetic waves for ground level may be swept to examine the frequency of the resonant electromagnetic waves for ground level in advance.

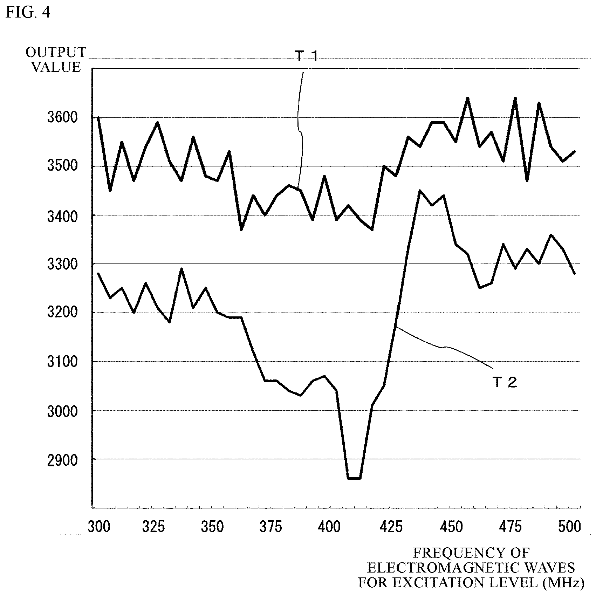

FIG. 4 is a graph showing the emission intensity of the spin defect 2a when the frequency of the resonant electromagnetic waves for ground level is fixed and the frequency of the electromagnetic waves for excitation level is changed in a predetermined frequency band. Specifically, FIG. 4 is a graph showing the emission intensity obtained by a test in which the frequency of the resonant electromagnetic waves for ground level is fixed to the resonance frequency (70 MHz) of the ground level and the electromagnetic waves for excitation level is changed (frequency is swept) by 5 MHz in a frequency band of 300 MHz to 500 MHz. In addition, the test according to FIG. 4 was performed twice while changing the intensity of the electromagnetic waves for excitation level. Specifically, the intensity of the electromagnetic waves for excitation level was increased in the order of the first test and the second test. FIG. 4 illustrates the emission intensity (output value) of the spin defect 2a in the first test as an emission intensity T1 in the first test and the output value in the second test as an emission intensity T2 in the second test.

As shown in FIG. 4, in both the emission intensity T1 in the first test and the emission intensity T2 in the second test, when the frequency of the electromagnetic waves for excitation level is around 410 MHz, the emission intensity greatly changes (emission intensity greatly decreases). This is because, when the frequency of the electromagnetic waves for excitation level coincides with the resonance frequency of the excitation level, a phenomenon occurs in which electrons are brought into a resonance state in the excited state.

As described above, the frequency of the electromagnetic waves for excitation level is swept, and an emission intensity change point (emission intensity change frequency) at which the emission intensity greatly changes (peak of change in emission intensity appears) corresponds to the resonance frequency of the excitation level. For example, within the range of the sweep frequency band, sweeping is performed by sequentially changing the initial frequency of the electromagnetic waves for excitation level by a predetermined frequency (e.g., any frequency of 1 MHz to 10 MHz), and the emission intensity of the spin defect 2a is detected for each individual changed frequency of the electromagnetic waves for excitation level. The resonance frequency of the excitation level of SiC-VSi has high temperature dependency and changes according to the temperature. That is, the emission intensity change frequency in the emission intensity spectrum obtained by changing the frequency of the electromagnetic waves for excitation level changes according to the temperature. Note that a frequency band (sweep frequency band) for changing the frequency of the electromagnetic waves for excitation level includes an excitation resonance frequency that resonates at least at the excitation level, and is appropriately set according to a physical quantity to be detected.

That is, the sweep frequency band is a frequency band including a range from a frequency lower than the excitation resonance frequency to a frequency higher than the excitation resonance frequency. The initial frequency of the electromagnetic waves for excitation level is set within the sweep frequency band.

The physical quantity detection device 1 configured as described above executes temperature detection processing of detecting a temperature on the basis of the emission intensity of the spin defect 2a obtained by applying excitation energy to the spin defect 2a under irradiation of the resonant electromagnetic waves for ground level and the electromagnetic waves for excitation level. In this temperature detection processing, the frequency of the resonant electromagnetic waves for ground level is fixed to the resonant frequency of the ground level, and the frequency is swept in a predetermined frequency band of the electromagnetic waves for excitation level.

In addition, in execution of the temperature detection processing, the frequency of the resonant electromagnetic waves for ground level is set according to the type of the spin defect 2a, and the detection data 77 indicating a temperature detection condition based on the relationship between the temperature and the emission intensity change frequency is created in advance.

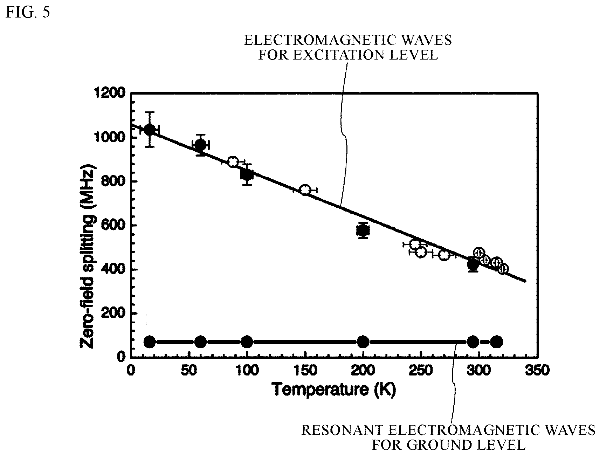

FIG. 5 is an explanatory diagram illustrating an example of the temperature detection condition in SiC-VSi that is the spin defect 2a of the present embodiment. As described above, the resonance frequency of the ground level of SiC-VSi has low temperature dependency, and the resonance frequency of the excitation level of SiC-VSi has high temperature dependency. FIG. 5 is a correlation table between the emission intensity change frequency and the temperature when the frequency of the resonant electromagnetic waves for ground level is fixed to the resonance frequency (70 MHz) of the ground level of SiC-VSi and the electromagnetic waves for excitation level is swept in the frequency band of 400 MHz to 1060 MHz using these characteristics (cited from A. N. Anisimov et al. Scientific reports 6 33301 (2016)).

The emission intensity change frequency is detected by the temperature detection processing as described above, and the temperature corresponding to the emission intensity change frequency can be detected from the correlation table illustrated in FIG. 5. In addition, an absolute temperature (K) can be calculated from the correlation table of FIG. 5 or the test results of FIG. 5 by the following formula [Expression 1].

[Expression 1]

$$K = (1060\text{-}RF)/2.1$$

In addition, the Celsius temperature (°C) can be calculated by the following formula [Expression 2].

[Expression 2]

$$°C = (1060\text{-}RF)/2.1\text{-}273.15$$

Here, RF in [Expression 1] and [Expression 2] is an emission intensity change frequency (MHz). Note that in the correlation table of FIG. 5, there is no test result at a temperature of 320 K or more, but it is considered that the tendency of the correlation between the emission intensity change frequency and the temperature expressed by the above [Expression 1] will continue.

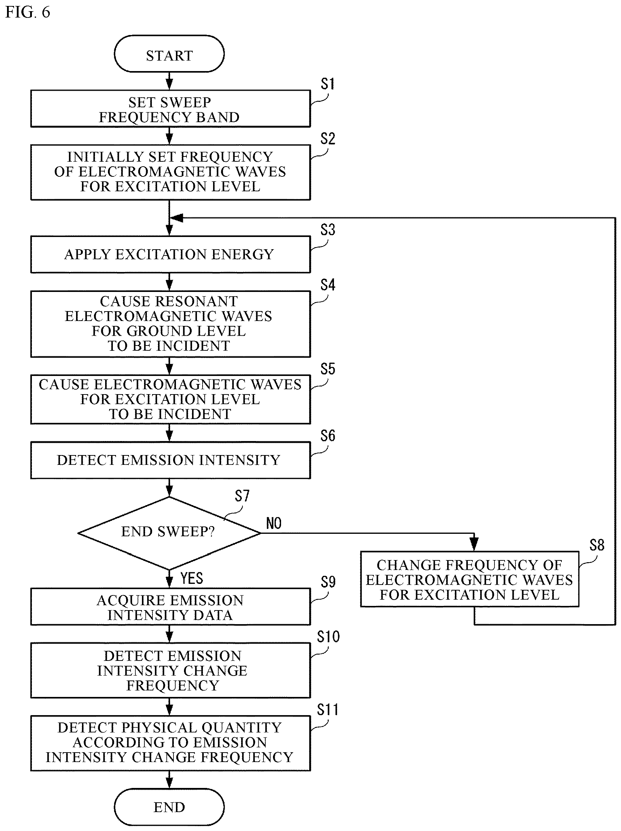

FIG. 6 is a flowchart illustrating physical quantity detection processing executed by the control unit 6. When starting the physical quantity detection processing, the control unit 6 first sets a sweep frequency band (step S1). Here, the sweep frequency band is set according to the environment in which the temperature detection processing is performed using the physical quantity detection device 1. For example, when the physical quantity to be detected is temperature and temperature detection processing is performed in an environment of about room temperature, the sweep frequency band is set in a frequency band including 400 MHz (e.g., frequency band in range including 300 MHz to 500 MHz). In addition, since the emission intensity change frequency and the temperature are inversely proportional to each other, the sweep frequency band can be set to be lower than that in the case of room temperature in a high temperature environment, and the sweep frequency band can be set to be higher than that in the case of room temperature in a low temperature environment.

Subsequently, an initial frequency of the electromagnetic waves for excitation level is set (step S2). Note, however, that the initial frequency of the electromagnetic waves for excitation level is set within the sweep frequency band. Next, the excitation unit 4 is controlled to apply excitation energy to the quantum sensor 2 (spin defect 2a) (step S3), the resonant electromagnetic waves for ground level are incident on the quantum sensor 2 (spin defect 2a) (step S4), the electromagnetic waves for excitation level are incident on the quantum sensor 2 (spin defect 2a) (step S5), and emission intensity is detected (emission intensity data is acquired) (step S6).

When the emission intensity is detected in step S6, it is determined whether to end the sweep (step S7). Here, it is determined whether the emission intensity is detected for the required frequencies of the electromagnetic waves for excitation level within the range of the sweep frequency band. For example, when it is planned to sequentially change the initial frequency of the electromagnetic waves for excitation level by, for example, 1 MHz within the range of the sweep frequency band and detect the emission intensity for each frequency of the changed electromagnetic waves for excitation level, it is determined whether the emission intensity has been detected for all the planned frequencies.

When it is determined not to end the sweep (step S7: NO), the frequency of the electromagnetic waves for excitation level is changed (step S8), and the processing returns to step S3. That is, when it is determined not to end the sweep (step S7: NO), the processing of steps S3 to S8 is repeated. Note that in step S8, the frequency of the electromagnetic waves for excitation level is set to a frequency at which the emission intensity has not been detected yet. On the other hand, when it is determined to end the sweep (step S7: YES), the emission intensity data 76 (light emission spectrum in sweep frequency band) detected so far is acquired (step S9), the emission intensity change frequency is detected (step S10), the physical quantity is detected according to the emission intensity change frequency according to the detection condition of the physical quantity (step S11), and the physical quantity detection processing is ended.

According to the above configuration and operation, in the present embodiment, excitation energy is applied under the irradiation of resonant electromagnetic waves for ground level and electromagnetic waves for excitation level. Due to irradiation of the resonant electromagnetic waves for ground level, it is possible to obtain a higher change in emission intensity than the conventional case in which only the electromagnetic waves for excitation level are irradiated, and it is possible to improve the detection accuracy of physical quantity detection using the quantum sensor 2. In addition, by obtaining highly sensitive data, a physical quantity can be detected with less data (the number of tests can be reduced), and the detection time (measurement time) can be shortened. For example, the physical quantity detection device 1 can detect a temperature of a space in which the quantum sensor 2 is disposed and a temperature of an object (electronic device or the like) that abuts (comes into contact with) the quantum sensor 2.

In addition, in the above-described embodiment, the sweep frequency band including the excitation resonance frequency is set, and the emission intensity change frequency is detected by changing the frequency of the electromagnetic waves for excitation level having high temperature dependence in the sweep frequency band, so that the physical quantity can be efficiently detected by effectively utilizing the characteristics of SiC-VSi.

Furthermore, in the above-described embodiment, the combiner 33 combines the ground level signal and the excitation level signal, and the electromagnetic wave incident unit 3 emits both the resonant electromagnetic waves for ground level and the electromagnetic waves for excitation level. Therefore, the amplifier 34 and the antenna 35 can be shared for the resonant electromagnetic waves for ground level and the electromagnetic waves for excitation level. Therefore, the number of components can be reduced, and the configuration of physical quantity detection device 1 can be simplified.

A quantum sensor of the present invention corresponds to the quantum sensor 2 of the above embodiment. Similarly, excitation means corresponds to the excitation unit 4, first electromagnetic wave generation means corresponds to the first signal generation unit 31, second electromagnetic wave generation means corresponds to the second signal generation unit 32, electromagnetic wave incident unit corresponds to the antenna 35, light detection means corresponds to the light detection unit 5, a physical quantity detection unit corresponds to the physical quantity detection program and the control unit 6 operating according thereto, and combined electromagnetic wave generation means corresponds to the combiner 33. However, the present invention is not limited to the present embodiment, and various other embodiments can be adopted. In addition, the specific configurations and the like described in the above embodiment are merely examples, and can be appropriately changed according to the actual product.

For example, in the above embodiment, the electromagnetic wave incident unit 3 includes the amplifier 34, but the amplifier 34 can be omitted. In this way, the number of components can be reduced, and the configuration of the physical quantity detection device 1 can be simplified.

In addition, one or more of the electromagnetic wave incident unit 3, the excitation unit 4, and the light detection unit 5 included in the physical quantity detection device 1 may be provided separately from the physical quantity detection device 1 and be configured as a physical quantity detection system. Even in this case, effects similar to those of the above embodiment can be obtained.

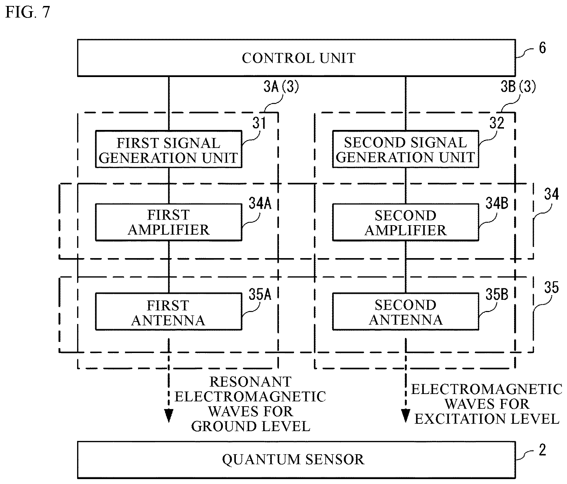

Furthermore, in the above embodiment, the electromagnetic wave incident unit 3 emits both the resonant electromagnetic waves for ground level and the electromagnetic waves for excitation level, but the present invention is not limited thereto. For example, as illustrated in FIG. 7, an electromagnetic wave incident unit 3 may include a ground level electromagnetic wave incident unit 3A that transmits resonant electromagnetic waves for ground level and an excitation level electromagnetic wave incident unit 3B that transmits electromagnetic waves for excitation level, which are provided independently of each other. In this case, the ground level electromagnetic wave incident unit 3A includes a first signal generation unit 31, a first amplifier 34A, and a first antenna 35A (first electromagnetic wave incident unit). The excitation level electromagnetic wave incident unit 3B includes a second signal generation unit 32, a second amplifier 34B, and a second antenna 35B (second electromagnetic wave incident unit). The first amplifier 34A and the second amplifier 34B have configurations similar to that of the amplifier 34 described above. The first antenna 35A and the second antenna 35B have configurations similar to that of the antenna 35 described above. With such a configuration, the combiner 33 can be omitted, and effects similar to those of the above embodiment can be obtained. Note that in FIG. 7, although illustration of the excitation unit 4, the light detection unit 5, the control unit 6, and the auxiliary storage unit 7 is omitted for convenience of description, configurations other than the electromagnetic wave incident unit 3 are the same as those of the above embodiment.

Furthermore, a modulation unit that modulates the amplitude or frequency of at least one of the resonant electromagnetic waves for ground level and the electromagnetic waves for excitation level may be provided. For example, as the modulation unit, a signal modulation function added to each signal generation unit outputting electromagnetic waves may be used, or an external modulation mechanism may be used. On the detection side, a lock-in amplifier may be provided between the light detection unit 5 and the control unit 6, or a detection mechanism corresponding thereto may be adopted. At this time, emission intensity data may be obtained by modulating one or both of the resonant electromagnetic waves for ground level and the electromagnetic waves for excitation level. The modulation scheme is preferably, but not limited to, amplitude modulation (AM) or frequency modulation (FM). In this way, noise included in the emission intensity data 76 can be removed, and the emission intensity change frequency of the measurement target can be efficiently detected.

In addition, in the above embodiment, the case in which the physical quantity to be measured is temperature in SiC-VSi has been described as an example. However, even in a case in which an electric field and pressure (strain) are detected by another quantum sensor using a spin defect, if the physical quantity is measured using an excitation level, detection can be performed by a similar method by appropriately setting a detection condition. Furthermore, the present invention can be provided not only as a physical quantity detection device but also as a method for detecting a physical quantity using a physical quantity detection device, a program, and a non-transitory tangible storage medium storing the program. In addition, the number of electromagnetic waves for excitation level that can be simultaneously generated by the second signal generation unit 32 (second electromagnetic wave generation means) can be one or more, and is not particularly limited. In a case in which the second signal generation unit 32 simultaneously generates a plurality of electromagnetic waves for excitation levels, the frequencies of the plurality of electromagnetic waves for excitation levels can be different from each other.

Industrial Applicability

The invention can be used in an industry in which a quantum sensor is used to detect a physical quantity.

Reference Signs List

1 physical quantity detection device
2 quantum sensor
2a spin defect
3 electromagnetic wave incident unit
31 first signal generation unit
32 second signal generation unit
33 combiner
34 amplifier
35 antenna
4 excitation unit
5 light detection unit
6 control unit

**Claims**

1. A physical quantity detection device comprising:

   a quantum sensor that has a spin defect;
   excitation means that applies excitation energy to the spin defect;
   first electromagnetic wave generation means that generates resonant electromagnetic waves for ground level of the spin defect;
   second electromagnetic wave generation means that generates electromagnetic waves for excitation level of the spin defect;
   an electromagnetic wave incident unit that causes the resonant electromagnetic waves for ground level and the electromagnetic waves for excitation level to be incident on the spin defect;
   light detection means that detects emission intensity of the spin defect when receiving the excitation energy, the resonant electromagnetic waves for ground level, and the electromagnetic waves for excitation level; and
   a physical quantity detection unit that detects a physical quantity on the basis of the emission intensity detected by the light detection means.

2. The physical quantity detection device according to claim 1, wherein
   the second electromagnetic wave generation means changes a frequency of the electromagnetic waves for excitation level in a frequency band including a range from a frequency lower than an excitation resonance frequency that resonates at an excitation level of the spin defect to a frequency higher than the excitation resonance frequency.

3. The physical quantity detection device according to claim 2, wherein
   the physical quantity detection unit acquires the emission intensity for each frequency of the changed electromagnetic waves for excitation level, and detects a physical quantity according to an emission intensity change frequency at which a peak of a change in the emission intensity appears.

4. The physical quantity detection device according to any one of claims 1, 2, or 3, further comprising combined electromagnetic wave generation means that generates combined electromagnetic waves obtained by combining the resonant electromagnetic waves for ground level and the electromagnetic waves for excitation level, wherein
the electromagnetic wave incident unit causes the combined electromagnetic waves to be incident on the spin defect.

5. The physical quantity detection device according to any one of claims 1, 2, or 3, wherein
the electromagnetic wave incident unit includes a first electromagnetic wave incident unit that causes the resonant electromagnetic waves for ground level to be incident on the spin defect and a second electromagnetic wave incident unit that causes the electromagnetic waves for excitation level to be incident on the spin defect.

6. The physical quantity detection device according to any one of claims 1 to 5, further comprising modulation means that modulates an amplitude or a frequency of at least one of the resonant electromagnetic waves for ground level and the electromagnetic waves for excitation level.

7. A physical quantity detection method that uses a physical quantity detection device including: a quantum sensor that has a spin defect; excitation means that applies excitation energy to the spin defect; first electromagnetic wave generation means that generates resonant electromagnetic waves for ground level of the spin defect; second electromagnetic wave generation means that generates electromagnetic waves for excitation level of the spin defect; an electromagnetic wave incident unit that causes the resonant electromagnetic waves for ground level and the electromagnetic waves for excitation level to be incident on the spin defect; and light detection means that detects emission intensity of the spin defect, the method comprising

when receiving the excitation energy, the resonant electromagnetic waves for ground level, and the electromagnetic waves for excitation level, detecting emission intensity of the spin defect by the light detection means, and detecting a physical quantity on the basis of the detected emission intensity.

8. A computer-readable physical quantity detection program for controlling a physical quantity detection device, the physical quantity detection device including: a quantum sensor that has a spin defect; excitation means that applies excitation energy to the spin defect; first electromagnetic wave generation means that generates resonant electromagnetic waves for ground level of the spin defect; second electromagnetic wave generation means that generates electromagnetic waves for excitation level of the spin defect; and an electromagnetic wave incident unit that causes the resonant electromagnetic waves for ground level and the electromagnetic waves for excitation level to be incident on the spin defect, wherein the program causes the computer to function as

light detection means that detects emission intensity of the spin defect when receiving the excitation energy, the resonant electromagnetic waves for ground level, and the electromagnetic waves for excitation level, and
a physical quantity detection unit that detects a physical quantity on the basis of the emission intensity detected by the light detection means.

FIG. 1

FIG. 2

FIG. 3

FREQUENCY BAND OF RESONANT
ELECTROMAGNETIC WAVES
FOR GROUND LEVEL

OUTPUT
VALUE

G 1

G 2

G 3

FREQUENCY OF RESONANT
ELECTROMAGNETIC WAVES
FOR GROUND LEVEL (MHz)

12

FIG. 4

OUTPUT
VALUE

T 1

T 2

3600

3500

3400

3300

3200

3100

3000

2900

300    325    350    375    400    425    450    475    500

FREQUENCY OF
ELECTROMAGNETIC WAVES
FOR EXCITATION LEVEL (MHz)

FIG. 5

ELECTROMAGNETIC WAVES
FOR EXCITATION LEVEL

RESONANT ELECTROMAGNETIC WAVES
FOR GROUND LEVEL

FIG. 6

```
                    ┌─────────────┐
                    │    START    │
                    └──────┬──────┘
                           │
              ┌────────────▼────────────┐  S1
              │      SET SWEEP          │
              │   FREQUENCY BAND        │
              └────────────┬────────────┘
                           │              S2
              ┌────────────▼────────────┐
              │  INITIALLY SET FREQUENCY │
              │ OF ELECTROMAGNETIC WAVES │
              │   FOR EXCITATION LEVEL   │
              └────────────┬────────────┘
                           │
                           │              S3
              ┌────────────▼────────────┐
              │  APPLY EXCITATION ENERGY │
              └────────────┬────────────┘
                           │              S4
              ┌────────────▼────────────┐
              │   CAUSE RESONANT         │
              │ ELECTROMAGNETIC WAVES    │
              │   FOR GROUND LEVEL       │
              │   TO BE INCIDENT         │
              └────────────┬────────────┘
                           │              S5
              ┌────────────▼────────────┐
              │ CAUSE ELECTROMAGNETIC    │
              │ WAVES FOR EXCITATION     │
              │ LEVEL TO BE INCIDENT     │
              └────────────┬────────────┘
                           │              S6
              ┌────────────▼────────────┐
              │ DETECT EMISSION INTENSITY│
              └────────────┬────────────┘
                           │       S7
                      ◇────▼────◇  NO
                      │ END SWEEP?├──────►  S8
                      ◇────┬────◇      ┌──────────────────┐
                        YES│           │ CHANGE FREQUENCY │
                           │           │ OF ELECTROMAGNETIC│
                           │           │ WAVES FOR        │
                           │           │ EXCITATION LEVEL │
              ┌────────────▼────────────┐  S9  └──────────┘
              │   ACQUIRE EMISSION      │
              │   INTENSITY DATA        │
              └────────────┬────────────┘
                           │              S10
              ┌────────────▼────────────┐
              │   DETECT EMISSION       │
              │   INTENSITY CHANGE      │
              │   FREQUENCY             │
              └────────────┬────────────┘
                           │              S11
              ┌────────────▼────────────┐
              │ DETECT PHYSICAL QUANTITY │
              │ ACCORDING TO EMISSION    │
              │ INTENSITY CHANGE FREQUENCY│
              └────────────┬────────────┘
                           │
                    ┌──────▼──────┐
                    │     END     │
                    └─────────────┘
```

FIG. 7

CONTROL UNIT — 6

3A (3)                                    3B (3)

31                                        32

FIRST SIGNAL
GENERATION UNIT                  SECOND SIGNAL
                                 GENERATION UNIT

34A                                       34B        34

FIRST
AMPLIFIER                        SECOND
                                 AMPLIFIER

35A                                       35B        35

FIRST
ANTENNA                          SECOND
                                 ANTENNA

RESONANT
ELECTROMAGNETIC                  ELECTROMAGNETIC
WAVES FOR                        WAVES FOR
GROUND LEVEL                     EXCITATION LEVEL

QUANTUM SENSOR — 2

<div style="text-align: center">**INTERNATIONAL SEARCH REPORT**</div>

| International application No. |
| --- |
| **PCT/JP2022/045713** |

| A. | CLASSIFICATION OF SUBJECT MATTER |
| --- | --- |

*G01N 24/10*(2006.01)i
FI:  G01N24/10 510Z; G01N24/10 510M

According to International Patent Classification (IPC) or to both national classification and IPC

| B. | FIELDS SEARCHED |
| --- | --- |

Minimum documentation searched (classification system followed by classification symbols)

G01N24/00-24/14; G01R33/00-33/64; G01K7/00-7/42

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JMEDPlus/JST7580 (JDreamIII)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | WO 2020/071383 A1 (UNIV KYOTO) 09 April 2020 (2020-04-09) | 1, 4-8 |
|  | paragraphs [0017]-[0067], fig. 1-9 |  |
| A |  | 2-3 |
| A | JP 2021-193377 A (SOMALOGIC, INC.) 23 December 2021 (2021-12-23) | 1-8 |
|  | entire text, all drawings |  |
| A | US 2016/0231394 A1 (LOCKHEED MARTIN CORPORATION) 11 August 2016 (2016-08-11) | 1–8 |
|  | entire text, all drawings |  |
| A | DE 102020204022 A1 (FRAUNHOFER-GESELLSCHAFT ZUR FOERDERUNG DER ANGEWANDTEN FORSCHUNG EINGETRAGENER VEREIN) 30 September 2021 (2021-09-30) | 1–8 |
|  | entire text, all drawings |  |

☑ Further documents are listed in the continuation of Box C.  ☑ See patent family annex.

| * Special categories of cited documents: |
| --- |

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **07 February 2023** | **21 February 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| International application No. |
| --- |
| **PCT/JP2022/045713** |

**C.    DOCUMENTS CONSIDERED TO BE RELEVANT**

| Category* | Citation of document, with indication, where appropriate, of the relevant passages | Relevant to claim No. |
| --- | --- | --- |
| A | 山下峻吾, ドレスト状態生成によるダイヤモンドNV中心のコヒーレンス時間の長時間化, 第67回応用物理学会春季学術講演会 講演予稿集, no. 14p-D221-1, 2020, p. 04-198<br>entire text, all drawings, (YAMASHITA, Shungo. Extension of Coherence Time of NV Centers in Diamond by the Generation of Dressed States.), non-official translation (Lecture preprints of The 67th JSAP Spring Meeting 2020) | 1-8 |
| A | ANISIMOV, A. N. Optical thermometry based on level anticrossing in silicon carbide. SCIENTIFIC REPORTS. 14 September 2016, vol. 6, no. 3301, pp. 1-5<br>entire text, all drawings | 1-8 |

Form PCT/ISA/210 (second sheet) (January 2015)

INTERNATIONAL SEARCH REPORT
Information on patent family members

International application No.

**PCT/JP2022/045713**

| Patent document cited in search report | | | Publication date (day/month/year) | Patent family member(s) | | | Publication date (day/month/year) |
|---|---|---|---|---|---|---|---|
| WO | 2020/071383 | A1 | 09 April 2020 | US | 2021/0396693 | A1 | |
| | | | | paragraphs [0078]-[0128], fig. 1-9 | | | |
| JP | 2021-193377 | A | 23 December 2021 | US | 2019/0277842 | A1 | |
| | | | | WO | 2019/173743 | A1 | |
| | | | | EP | 3762722 | A1 | |
| | | | | KR | 10-2020-0118227 | A | |
| | | | | CN | 112105929 | A | |
| US | 2016/0231394 | A1 | 11 August 2016 | WO | 2016/118791 | A1 | |
| | | | | EP | 3248021 | A1 | |
| | | | | KR | 10-2017-0140156 | A | |
| DE | 102020204022 | A1 | 30 September 2021 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10529416 B

**Non-patent literature cited in the description**

- **A. N. ANISIMOV et al.** *Scientific reports*, 2016, vol. 6, 33301